# EUROPEAN PATENT APPLICATION

(11) **EP 1 995 773 A2**
(43) Date of publication of application: **26.11.2008**
(21) Application number: 08156820.6
(22) Date of filing: 23.05.2008
(51) Int. Cl.: H01L 23/373

(54) **Semiconductor device with stress relaxation members**

(30) Priority: 25.05.2007 JP 2007139027
(71) Applicant: KABUSHIKI KAISHA TOYOTA JIDOSHOKKI, Kariya-shi, Aichi 448-8671 (JP); Showa Denko K.K., Tokyo 105-8518 (JP)
(72) Inventor: IWATA, Yoshitaka, Kariya-shi Aichi 448-8671 (JP); Toh, Keiji, Kariya-shi Aichi 448-8671 (JP); Tamura, Shinobu, Minato-ku Tokyo Tokyo 105-8518 (JP); Nakagawa, Shintaro, Minatao-ku Tokyo Tokyo 105-8518 (JP)
(74) Representative: TBK-Patent

(57) **Abstract**

A semiconductor device has a ceramic substrate having a first surface and a second surface, a metal layer that is coupled to the second surface, a heat sink that is coupled to the metal layer and a stress relaxation member. The stress relaxation member is arranged between the metal layer and the heat sink and has a first surface that is coupled to the metal layer and a second surface that is coupled to the heat sink. A plurality of stress relaxation spaces are provided over the entire surface of at least one of the first and second surfaces of the stress relaxation member. The stress relaxation spaces that are arranged at the outermost portions of the stress relaxation member are deeper than the other stress relaxation spaces.

## Description

### BACKGROUND OF THE INVENTION

The present invention relates to a semiconductor device including an insulated substrate having a first surface and a second surface, and a heat radiating device. The first surface is coupled to a semiconductor element, the second surface is coupled to a metal layer, and the heat radiating device is coupled to the metal layer through a plate-like stress relaxation member.

Conventionally, modularized semiconductor devices are known. In such a semiconductor device, metal layers are respectively provided on both of the front and back sides of a ceramic substrate (insulated substrate), which is, for example, made of aluminum nitride. A semiconductor element is thermally coupled (joined) to the front side metal layer, and a heat sink (radiator) is thermally coupled (joined) to the back side metal layer. The heat sink radiates heat generated by the semiconductor element. Such semiconductor devices are required to maintain heat radiating performance of the heat sink for an extended period of time. However, depending on the use conditions, cracks may occur at junction portions between the ceramic substrate and the back side metal layer due to thermal stress generated by the difference in coefficient of linear expansion between the metal layer and the heat sink. Further, when expanding, the cracks may cause peeling, which degrades the heat radiating performance.

To overcome such a drawback, Japanese Laid-Open Patent Publication No. 2006-294699 discloses a heat radiating device (semiconductor device). The heat radiating device disclosed in the publication has an insulated substrate having a first surface and a second surface, a metal layer, a stress relaxation member and a heat sink. The first surface functions as a surface on which a heat generating member is mounted, and the second surface is an opposite side of the first surface. The metal layer is formed on the second surface. The stress relaxation member is formed on the metal layer. The heat sink is formed on the relaxation member so that the heat sink is fixed to the second surface through the metal layer and the stress relaxation member. The stress relaxation member is formed of a highly thermal conductive material and has a stress absorbing space. The stress relaxation member is coupled to the insulated substrate and the heat sink through metal joining. This improves thermal conductivity between the insulated substrate and the heat sink and also improves heat radiating performance of heat which is generated from the heat generating member (semiconductor element). The heat generating member is mounted to the insulated substrate. Since the stress relaxation member is deformed such that the stress absorption space relaxes the thermal stress, cracks and peeling are prevented from occurring at junction portions between the insulated substrate and the metal layer.

In the heat radiating device disclosed in the above publication, a plurality of stress absorbing spaces are formed on an entire surface of a coupling surface of the stress relaxation member to which the metal layer is coupled. The stress absorbing space is a through-hole which extends through the stress relaxation member in its thickness direction or a recess portion formed so as to be recessed in a thickness direction of the stress relaxation member. The plurality of stress relaxation members have same depths. The stress absorbing spaces occupy a large area of the surface of the stress relaxation member, and the volume ratio of a material of the stress relaxation member to the stress absorbing space is small. Therefore, in the heat radiating device disclosed in the above publication, the thermal conductivity of the stress relaxation member is not good, and therefore the heat radiating performance is not good.

### SUMMARY OF THE INVENTION

An objective of the present invention is to provide a semiconductor device having a superior stress relaxing function and a superior heat radiating performance.

To achieve the above object, one aspect of the present invention provides a semiconductor device including an insulated substrate, a semiconductor element, a metal layer, a heat layer, a heat radiating device, and a plate-like stress relaxation member. The insulated substrate has a first surface and a second surface which is an opposite surface of the first surface. The semiconductor element is coupled to the first surface of the insulated substrate. The metal layer is coupled to the second surface of the insulated substrate. The heat radiating device is coupled to the metal layer. The plate-like stress relaxation member is arranged between the metal layer and the heat radiating device. The stress relaxation member has a first surface that is coupled to the metal layer and a second surface that is coupled to the heat radiating device. A plurality of stress relaxation spaces are formed over the entirety of at least one of the first surface and the second surface of the stress relaxation member. The stress relaxation spaces arranged at outermost portions of the stress relaxation member are deeper than the other stress relaxation spaces.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a plan view illustrating a semiconductor device according to a first embodiment of the present invention;
Fig. 2 is a cross-sectional view taken along line 2-2 of Fig. 1.
Fig. 3 is a plan view showing the stress relaxation member shown in Fig. 2;
Fig. 4 is a cross-sectional view taken along line 4-4 of Fig. 3.
Fig. 5 is a cross-sectional view illustrating a stress relaxation member according to a second embodiment;
Fig. 6 is a graph showing maximum plastic strain amplitudes according to Examples and Comparative Examples
Fig. 7A is a graph showing temperatures of IGBT according to Examples and Comparative Examples
Fig. 7B is a graph showing temperatures of diodes according to Examples and Comparative Examples
Figs. 8 to 10 are cross sectional views showing stress relaxation members according to modified embodiments.

### DETAILED DESCRIPTION OF THE PREFERRED EMBODIMENTS

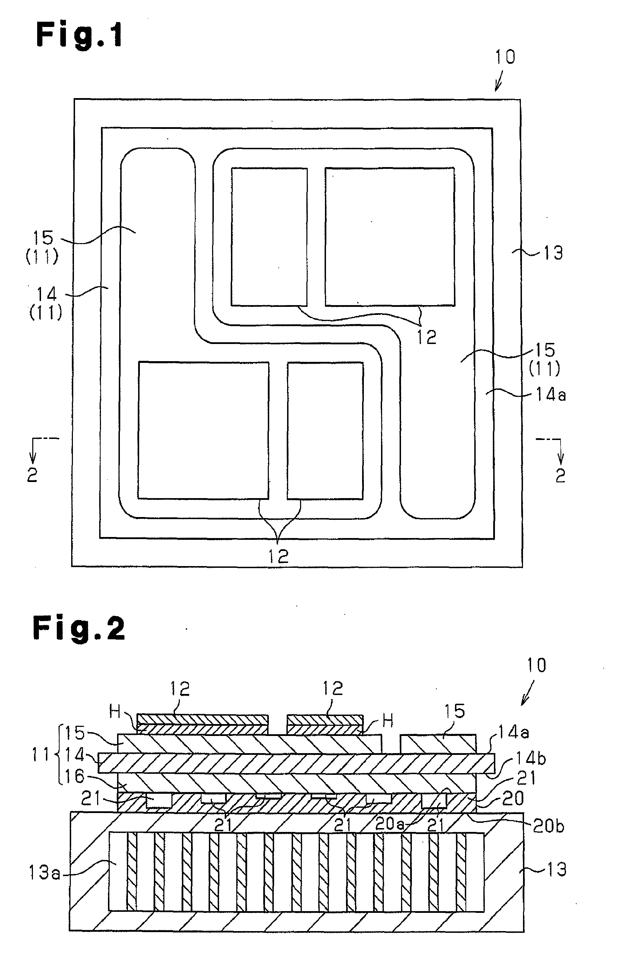

A semiconductor device according to a first embodiment of the present invention will now be described with reference to Figs. 1 to 4. Figs. 1 to 4 schematically show the semiconductor device. For the illustrative purposes, the ratios of the widths, the lengths, and the thicknesses of parts are different from the actual ratios.

As shown in Fig. 2, a semiconductor device 10 includes a circuit board 11, semiconductor elements 12 joined to the circuit board 11, a heat sink 13 functioning as a radiator, and a stress relaxation member 20 located between the circuit board 11 and the heat sink 13. Specifically, the circuit board 11 is provided with a ceramic substrate (insulated substrate) 14 that has a first surface 14a (front side) and a second surface 14b (back side), which is opposite to the first surface 14a. The circuit board 11 also includes metal circuits 15, which are joined to the first surface 14a, and a metal layer 16, which is joined to the second surface 14b (back side). The ceramic substrate 14 and the metal layer 16 are rectangular in a plan view. As shown in Figs. 1 and 2, the semiconductor elements 12 are rectangular in a plan view and are coupled to the metal circuits 15 with a solder layer H (see Fig. 2). Therefore, the semiconductor elements 12 are thermally coupled to the first surface 14a of the ceramic substrate 14 with the metal circuits 15. The semiconductor elements 12 are arranged at an inner portion from the edges of the circuit board 11.

The semiconductor elements 12 include, for example, an IGBT (Insulated Gate Bipolar Transistor), a MOSFET, and a diode. A plurality of semiconductor elements 12 are coupled to the circuit board 11. As shown in Fig. 2, the stress relaxation member 20 has a first surface 20a and a second surface 20b which is an opposite surface of the first surface. The first surface 20a is coupled to the metal layer 16 by brazing. The heat sink 13 is coupled to the second surface 20b by brazing. In other words, the stress relaxation member 20 is coupled to the ceramic substrate 14 and the heat sink 13 through metal joining, and therefore, the semiconductor elements 12 are thermally coupled to the heat sink 13 via the circuit board 11 and the stress relaxation member 20.

The ceramic substrate 14 is formed of, for example, aluminum nitride, alumina, or silicon nitride. The metal circuits 15 and the metal layer 16 are formed of aluminum. The heat sink 13 is formed of aluminum. The aluminum refers to aluminum and aluminum alloy. The metal circuits 15, the metal layer 16, and the heat sink 13 may be formed of a material having a highly thermal conductivity (for example, copper and copper alloys), other than aluminum. Cooling medium passages 13a, through which cooling medium (for example, cooling water) flows, are formed in the heat sink 13.

The stress relaxation member 20 will now be described in detail.

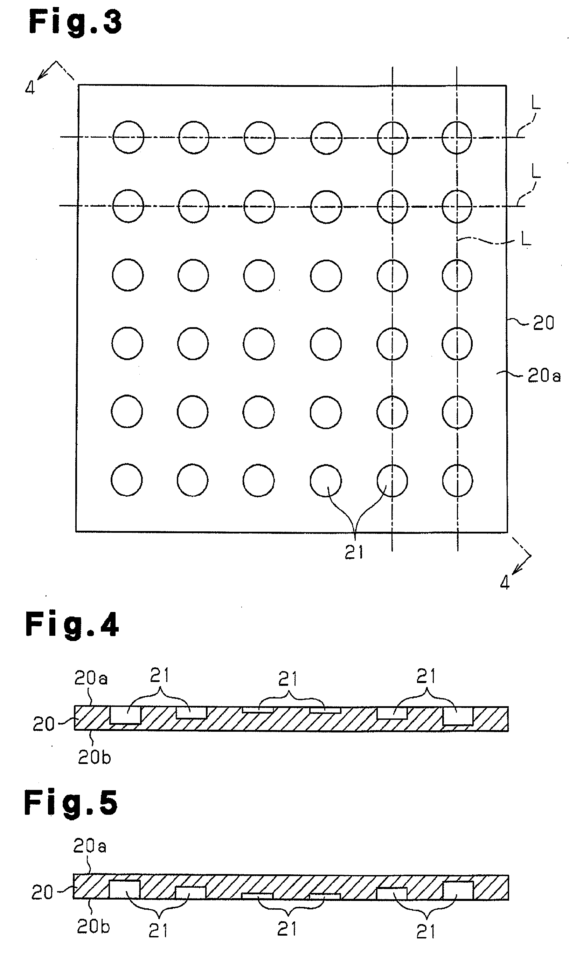

The stress relaxation member 20 shown in Fig. 2 is made of a highly thermal conductive material, that is specifically the same material as that of the metal layer 16 and the heat sink 13 (aluminum or copper). The stress relaxation member 20 is rectangular in a plan view (see Fig. 3).

A plurality of recesses 21 are formed, or stress relaxation spaces 21 are formed to be recessed over the entire surface of the first surface 20a of the stress relaxation member 20. Portions of the first surface 20a other than the stress relaxation spaces 21 are connected to the metal layer 16 by brazing. On the other hand, no stress relaxation space 21 is formed on the second surface 20b of the stress relaxation member 20, and the entire surface of the second surface 20b is coupled to the heat sink 13 by brazing. As shown in Fig. 3, each of the stress relaxation spaces 21 is circular in a plan view. As shown in Fig. 2, each of the stress relaxation spaces 21 is formed so as to be recessed along the thickness direction of the stress relaxation member 20 from the first surface 20a of the stress relaxation member 20 to the second surface 20b. Each of the stress relaxation spaces 21 relaxes the thermal stress when the thermal stress is generated in the semiconductor device 10.

As shown in Fig. 3, the stress relaxation spaces 21 are arranged regularly such that lines L (shown by a dashed-dotted line) passing through centers of the stress relaxation spaces 21 and extending parallel with a side of the stress relaxation member 20 are arranged in a grid. All the distances between the stress relaxation spaces 21 arranged along a side of the stress relaxation member 20 are the same. Further, some of the stress relaxation spaces 21 are arranged such that the centers are positioned on a diagonal of the stress relaxation member 20. All the distances between the stress relaxation spaces 21 arranged along a diagonal of the stress relaxation member 20 are the same.

In the present embodiment, on the first surface 20a of the stress relaxation member 20, six stress relaxation spaces 21 are arranged along a direction in which a pair of opposite sides of the stress relaxation member 20 extend. Six stress relaxation spaces 21 are arranged along a direction in which another pair of sides, which are perpendicular to the first pair of opposite sides, extend. In other words, thirty six (six lines by six columns) stress relaxation spaces 21 are provided on the stress relaxation member 20. All the stress relaxation spaces 21 are formed to be within a thickness range of the stress relaxation member 20 and do not extend through the stress relaxation member 20.

As shown in Figs. 2 and 4, twenty stress relaxation spaces 21 that are arranged at the outermost portions of the stress relaxation member 20, or the stress relaxation spaces 21 that are arranged along the edges of the stress relaxation member 20 are deeper than the other sixteen stress relaxation spaces 21. The stress relaxation spaces 21 that are arranged along the edges of the stress relaxation member 20 are referred to as the stress relaxation spaces 21 of a first group. The stress relaxation spaces 21 of the first group have depths closer to a thickness of the stress relaxation member 20. The stress relaxation spaces 21 of the first group are deepest in all of the stress relaxation spaces 21.

The twelve stress relaxation spaces 21 that are arranged inside of and adjacent to the stress relaxation spaces 21 of the first group are shallower than the stress relaxation spaces 21 of the first group. The stress relaxation spaces 21 that are arranged inside of and adjacent to the stress relaxation spaces 21 of the first group are referred to as the stress relaxation spaces 21 of a second group. The depth of the stress relaxation spaces 21 of the second group is half the depth of the stress relaxation spaces 21 of the first group.

Further, the four stress relaxation spaces 21 which are arranged at a center of the stress relaxation member 20 and arranged inside of the stress relaxation spaces 21 of the second group are shallower than the stress relaxation spaces 21 of the second group. The four stress relaxation spaces 21 which are arranged inside of the stress relaxation spaces 21 of the second group are referred to as the stress relaxation spaces 21 of a third group. The depths of the stress relaxation spaces 21 of the third group are half of those of the stress relaxation spaces 21 of the second group. Therefore, the stress relaxation spaces 21 of the third group are shallowest in all of the stress relaxation spaces 21. The stress relaxation spaces 21 of a plurality of groups have different depths. The stress relaxation spaces 21 become shallower as it gets closer to the center of the stress relaxation member 20.

The semiconductor device 10 configured as described above is applied, for example, to a driving device of a vehicle electric motor, and controls electricity supplied to the vehicle electric motor in accordance with the driving conditions of the vehicle. Also, heat generated by the semiconductor elements 12 in the semiconductor device 10 is conducted to the heat sink 13 through the metal circuits 15, the ceramic substrate 14, the metal layer 16, and the stress relaxation member 20. When the heat generated by the semiconductor elements 12 is conducted to the heat sink 13, the circuit board 11 and the heat sink 13 are heated and thermally expanded. When the semiconductor elements 12 stops generating heat, the temperature of the circuit board 11 and the heat sink 13 is lowered, and the circuit board 11 and the heat sink 13 are thermally shrunk. At thermal expansion and thermal shrinkage, thermal stress is generated in the semiconductor device 10 due to the difference in coefficient of linear expansion between the heat sink 13 and the ceramic substrate 14.

However, since the semiconductor device 10 of the present embodiment has the stress relaxation spaces 21 formed in the stress relaxation member 20, the stress relaxation spaces 21 allow deformation of the stress relaxation member 20, and the thermal stress acting on the semiconductor device 10 is relaxed. At this time, the thermal stress is greater as it gets closer to the edges of the semiconductor device 10. The stress relaxation spaces 21 of the first group are deepest in all of the stress relaxation spaces 21. In other words, the deepest and largest stress relaxation spaces 21 are arranged at the portions on which the largest thermal stress acts. Therefore, the stress relaxation member 20 allows great deformation at its edges and reliably relaxes the thermal stress. The thermal stress is smaller toward the center of the stress relaxation member 20. Therefore, the stress relaxation spaces 21 of the second and third groups having shallow depths are arranged inside of the stress relaxation spaces 21 of the first group. Therefore, the small thermal stress can be effectively relaxed by the stress relaxation spaces 21 of the second and third groups.

Also, heat generated by the semiconductor elements 12 is conducted to the heat sink 13 through the ceramic substrate 14, the metal layer 16, and the stress relaxation member 20 (coupling region). The heat conducted to the heat sink 13 is then conducted to the cooling medium flowing through the cooling medium passages 13a in the heat sink 13, and removed. That is, since the heat sink 13 is forcibly cooled by the cooling medium flowing through the cooling medium passages 13a, the heat generated by the semiconductor elements 12 is efficiently removed. As a result, the semiconductor elements 12 are cooled from the side closer to the circuit board 11.

In the semiconductor device 10, a part of the first surface 20a of the stress relaxation member 20 is located directly below the semiconductor elements 12 through the circuit board 11. Thus, heat that is conducted directly downward from the semiconductor elements 12 is conducted to the heat sink 13 through the stress relaxation member 20.

The stress relaxation spaces 21 are arranged on the first surface 20a of the stress relaxation member 20 for relaxing the thermal stress. The stress relaxation spaces 21 of the third group that are arranged closer to the center of the stress relaxation member 20 are shallowest. The stress relaxation spaces 21 become deeper toward the edges of the stress relaxation member 20. Therefore, the ratio of a volume that is occupied by the stress relaxation spaces 21 with respect to the stress relaxation member 20 is reduced toward the center of the stress relaxation member 20. That is, the volume ratio of the material that forms the stress relaxation member 20 with respect to the stress relaxation spaces 21 becomes greater toward the center of the stress relaxation member 20. Therefore, the thermal conductivity of the stress relaxation member 20 is improved and heat generated from the semiconductor elements 12 is efficiently conducted to the heat sink 13 through the stress relaxation member 20.

The embodiment has the following advantages.
(1) The stress relaxation member 20 is provided between the metal layer 16 and the heat sink 13 on the circuit board 11 and a plurality of stress relaxation spaces 21 are formed to be recessed on the entire surface of the first surface 20a of the stress relaxation member 20. The stress relaxation spaces 21 (of the first group) which are arranged closer to the edges of the stress relaxation member 20 are deeper than the other stress relaxation spaces 21 (of the second and third groups). Therefore, the largest stress relaxation spaces 21 are arranged closer to the edges of the semiconductor device 10 where the thermal stress is concentrated. Accordingly, the thermal stress is reliably relaxed by the stress relaxation spaces 21. The volume ratio of the material that forms the stress relaxation member 20 to the stress relaxation spaces 21 becomes greater toward the center of the stress relaxation member 20. Therefore, the thermal conductivity of the stress relaxation member 20 is improved compared to a case in which all the stress relaxation spaces 21 are formed to have the same depths as the stress relaxation spaces 21 of the first group. Accordingly, the semiconductor device 10 having the stress relaxation member 20 has superior stress relaxation function and prevents cracks and peeling from occurring at junction portions with the ceramic substrate 14 and also has superior heat radiating performance.
(2) A plurality of stress relaxation spaces 21 are formed on the first surface 20a of the stress relaxation member 20, and therefore the portions of the first surface 20a other than the portions where the stress relaxation spaces 21 are formed are coupled to the metal layer 16. When the stress relaxation member 20 is coupled to the metal layer 16 via brazing, the stress relaxation spaces 21 allow the brazing material to flow into the stress relaxation spaces 21. From the view point of wettability, the coupling between the metal layer 16 and the stress relaxation member 20 is improved compared to a case in which the entire surface of the stress relaxation member 20 is coupled to the metal layer 16.
(3) The thermal stress acting on the semiconductor device 10 becomes greater toward the edges of the stress relaxation member 20 and becomes smaller toward the center of the stress relaxation member 20. The stress relaxation spaces 21 become shallower toward the center of the stress relaxation member 20. Therefore, the magnitudes of the thermal stress acting on the outer portion and the inner portion of the semiconductor device 10 are different. However, the depths of the stress relaxation spaces 21 are adjusted to correspond to the magnitude of the thermal stress acting on each portion. Therefore, the thermal stress is efficiently relaxed.
(4) The stress relaxation spaces 21 are arranged regularly over the entire surface of the first surface 20a of the stress relaxation member 20. Therefore, for example, compared to a case in which the stress relaxation spaces 21 are arranged to be concentrated on a part of the first surface and there are some portions on the first surface 20a where no stress relaxation space 21 is formed, the stress relaxation member 20 reliably relaxes the thermal stress by the stress relaxation spaces 21 and has superior heat radiating performance.
(5) In the semiconductor device 10, the thermal stress is generated by the difference in coefficient of linear expansion between the ceramic substrate 14 and the heat sink 13, and the thermal stress easily influences on the junction portion of the ceramic substrate 14 and the metal layer 16. The stress relaxation spaces 21 are provided on the first surface 20a, which is one of the first surface 20a and the second surface 20b of the stress relaxation member 20, closer to the junction portion of the ceramic substrate 14 and the metal layer 16. Therefore, the thermal stress is effectively relaxed, and cracks and peeling are effectively prevented from occurring at the junction portion of the ceramic substrate 14 and the metal layer 16.

A semiconductor device according to a second embodiment of the present invention will be explained with reference to Fig. 5.

As shown in Fig. 5, a plurality of stress relaxation spaces 21 are formed over the entire surface of the second surface 20b of the stress relaxation member 20. Each of the stress relaxation spaces 21 is formed to be recessed from the second surface 20b to the first surface 20a of the stress relaxation member 20. The second embodiment differs from the first embodiment in the surface on which the stress relaxation spaces 21 are formed. However, the depths, the arrangement and the number of the first to third stress relaxation spaces 21 of the second embodiment are the same as the first embodiment. Therefore, according to the second embodiment, the advantages of (1) to (4) of the first embodiment are obtained.

The embodiments will be explained in details based on Examples. Examples do not limit the present invention.

### Example 1

The stress relaxation member 20 according to the first embodiment was configured as follows.

The thickness of the stress relaxation member 20 was 2.0 mm, the depth of the stress relaxation spaces 21 of the first group was 1.5 mm, the depth of the stress relaxation spaces 21 of the second group was 1.0 mm, and the depth of the stress relaxation spaces 21 of the third group was 0.5 mm.

### Example 2

The stress relaxation member 20 according to the second embodiment was configured as follows.

The thickness of the stress relaxation member 20 was 2.0 mm, the depth of the stress relaxation spaces 21 of the first group was 1.5 mm, the depth of the stress relaxation spaces 21 of the second group was 1.0 mm, and the depth of the stress relaxation spaces 21 of the third group was 0.5 mm.

### Comparative Example 1

The thickness of the stress relaxation member was 2.0 mm and no stress relaxation spaces were formed.

### Comparative Example 2

The thickness of the stress relaxation member was 2.0 mm and all the stress relaxation spaces were formed to extend through the stress relaxation member 20.

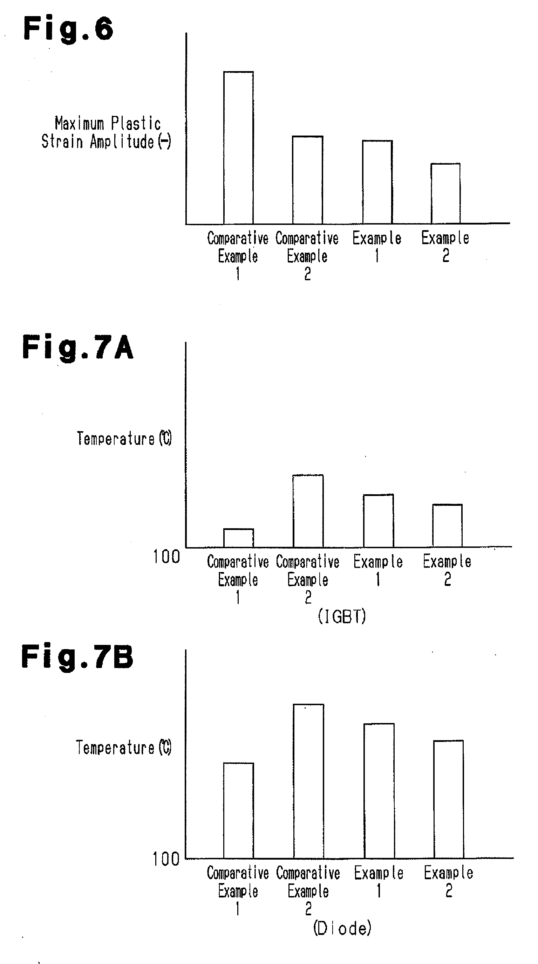

In the semiconductor devices in which the stress relaxation members of Examples 1 and 2 and Comparative Examples 1 and 2 were used, the maximum plastic strain amplitude of the metal layer (which corresponds to the thermal stress in each embodiment) was measured. The results are shown in Fig. 6. In Fig. 6, the vertical axis represents the maximum plastic strain amplitude (-), and the horizontal axis represents an object to be measured. As shown in Fig. 6, the maximum plastic strain amplitude (thermal stress) was extremely lowered in Examples 1 and 2 compared to Comparative Example 1. In Examples 1 and 2, the value that was substantially the same as the maximum plastic strain amplitude (thermal stress) of Comparative Example 2 was obtained. This shows that the stress relaxation members of Examples 1 and 2 had superior stress relaxing function.

The semiconductor devices used the stress relaxation members of Examples 1 and 2 and Comparative Examples 1 and 2. For each of Examples 1 and 2 and Comparative Examples 1 and 2, two semiconductor devices one of which used an IGBT as a semiconductor element and another one of which used a diode as a semiconductor element were prepared. The area of the IGBTA was 139.24 mm² and the heating value was 102 W. On the other hand, the area of the diode was 69.3 mm² and the heating value was 75 W. Therefore, the heating value per a unit area was greater in the diode than the IGBT.

The temperature of the semiconductor element (IGBT and diode) in each of the semiconductor devices was measured. The results are shown in Figs. 7A and 7B. In Figs. 7A and 7B, the vertical axis represents a temperature (°C) and the horizontal axis represents an object to be measured. Fig. 7A shows a temperature of the IGBT and Fig. 7B shows a temperature of the diode. As shown in Figs. 7A and 7B, the temperature of the semiconductor element was low in Examples 1 and 2 compared to Comparative Example 2. This shows that the heat radiating performance in the semiconductor device was improved.

Thus, it was found out that the configuration in which the stress relaxation spaces 21 arranged at the outermost portions of the stress relaxation member 20 are deepest and the stress relaxation spaces 21 become shallower toward the center of the stress relaxation member 20 allows the stress relaxation member 20 to have stress relaxing function and superior heat radiating effects.

It should be apparent to those skilled in the art that the present invention may be embodied in many other specific forms without departing from the spirit or scope of the invention. Particularly, it should be understood that the invention may be embodied in the following forms.

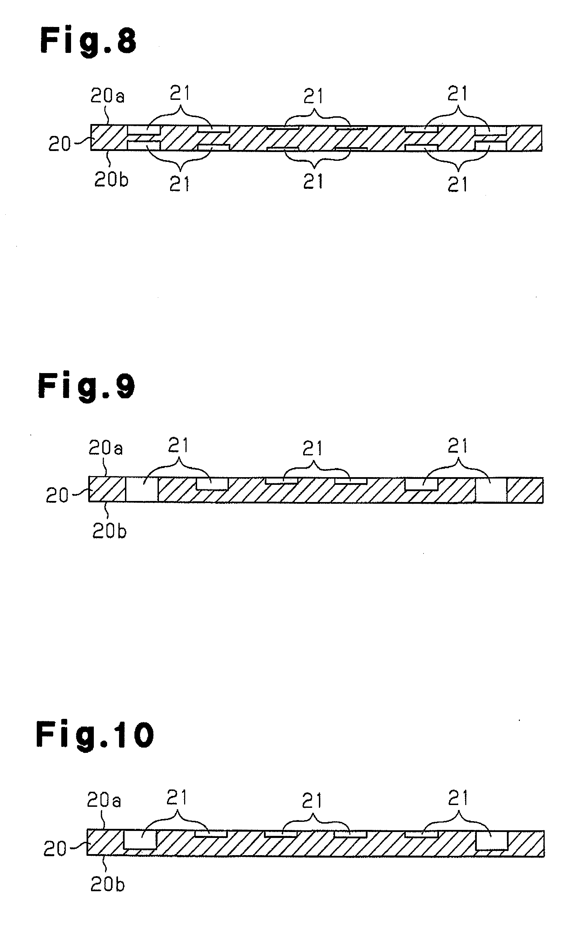

As shown in Fig. 8, the stress relaxation spaces 21 may be formed to be recessed on the both surfaces including the first surface 20a and the second surface 20b of the stress relaxation member 20. The stress relaxation spaces 21 may become shallower toward the center of the stress relaxation member 20.

As shown in Fig. 9, the stress relaxation spaces 21 arranged at the outermost portions of the stress relaxation member 20 (the stress relaxation spaces 21 of the first group) may be formed so as to extend through the stress relaxation member 20. Further, on the first surface 20a or the second surface 20b (on the first surface 20a in Fig. 9), the stress relaxation spaces 21 of the second and third groups may be formed so as to be recessed in the thickness direction of the stress relaxation member 20, and the stress relaxation spaces 21 of the second group arranged at the outermost portions may be deeper than the stress relaxation spaces 21 of the third group. Accordingly, the depths of the stress relaxation spaces 21 at the outermost portions of the stress relaxation member 20 where the thermal stress is concentrated are deepest possible in the thickness direction of the stress relaxation member 20. Therefore, the thermal stress can be reliably relaxed by the stress relaxation spaces 21.

As shown in Fig. 10, the stress relaxation spaces 21 arranged at the outermost portions of the stress relaxation member 20 (the stress relaxation spaces 21 of the first group) may be deepest and the depths of the other stress relaxation spaces 21 may be same.

The number of the stress relaxation spaces 21 arranged on at least one of the first surface 20a and the second surface 20b of the stress relaxation member 20 may be varied according to the size of the stress relaxation member 20 and the size of the semiconductor elements 12.

In each of the embodiments, the plan shape of the stress relaxation space 21 is not limited to be a circle. For example, the plan shape of the stress relaxation space 21 may be a triangle, a rectangle, an oval, a hexagon or other shapes.

The stress relaxation spaces 21 may be arranged in a zigzag arrangement on at least one of the first surface 20a and the second surface 20b.

The cooling medium flowing through the heat sink 13 is not limited to water as long as the heat sink 13 is a cooling device of a forcibly cooling type. For example, the cooling medium may be other liquid or gas such as air. The heat sink 13 may be a cooling device of an ebullient boiling type.

The number of the metal circuits 15 provided on the circuit board 11 is not limited to two. The number of the metal circuits 15 may be one or three or more. The number of the semiconductor elements 12 provided on each metal circuit 15 may be one or three or more.

The semiconductor device 10 is not necessarily used for being mounted to a vehicle but may be used for other purposes.

The present examples and embodiments are to be considered as illustrative and not restrictive and the invention is not to be limited to the details given herein, but may be modified within the scope and equivalence of the appended claims.

A semiconductor device has a ceramic substrate having a first surface and a second surface, a metal layer that is coupled to the second surface, a heat sink that is coupled to the metal layer and a stress relaxation member. The stress relaxation member is arranged between the metal layer and the heat sink and has a first surface that is coupled to the metal layer and a second surface that is coupled to the heat sink. A plurality of stress relaxation spaces are provided over the entire surface of at least one of the first and second surfaces of the stress relaxation member. The stress relaxation spaces that are arranged at the outermost portions of the stress relaxation member are deeper than the other stress relaxation spaces.

## Claims

1. A semiconductor device comprising:
an insulated substrate (14) having a first surface (14a) and a second surface (14b) which is an opposite surface of the first surface (14a);
a semiconductor element (12) that is coupled to the first surface (14a) of the insulated substrate (14);
a metal layer (16) that is coupled to the second surface (14b) of the insulated substrate (14);
a heat radiating device (13) that is coupled to the metal layer (16); and
a plate-like stress relaxation member (20) arranged between the metal layer (16) and the heat radiating device (13), the stress relaxation member (20) having a first surface (20a) that is coupled to the metal layer (16) and a second surface (20b) that is coupled to the heat radiating device (13),
**characterized in that** a plurality of stress relaxation spaces (21) are formed over the entirety of at least one of the first surface (20a) and the second surface (20b) of the stress relaxation member (20), and the stress relaxation spaces (21) arranged at outermost portions of the stress relaxation member (20) are deeper than the other stress relaxation spaces (21).

2. The semiconductor device according to claim 1, **characterized in that** the stress relaxation spaces (21) become shallower toward a center of the stress relaxation member (20).

3. The semiconductor device according to claim 1, **characterized in that** the stress relaxation spaces (21) are formed on the first surface (20a) of the stress relaxation member (20), and the stress relaxation spaces (21) become shallower toward a center of the stress relaxation member (20).

4. The semiconductor device according to claim 1, **characterized in that** the stress relaxation spaces (21) are formed on the second surface (20b) of the stress relaxation member (20), and the stress relaxation spaces (21) become shallower toward a center of the stress relaxation member (20) .

5. The semiconductor device according to claim 1, **characterized in that** the stress relaxation spaces (21) are recessed portions.

6. The semiconductor device according to any one of claims 1 to 5, **characterized by** the stress relaxation spaces (21) that are arranged at outermost portions of the stress relaxation member (20) extend through the stress relaxation member (20) in its thickness direction.

7. The semiconductor device according to any one of claims 1 to 6, **characterized in that** the stress relaxation spaces (21) are regularly arranged such that a plurality of lines (L) passing through centers of the stress relaxation spaces (21) and extending along sides of the stress relaxation member (20) are arranged in a grid.
